# EUROPEAN PATENT APPLICATION

(11) **EP 1 755 160 A1**
(43) Date of publication of application: **21.02.2007**
(21) Application number: 06118860.3
(22) Date of filing: 14.08.2006
(51) Int. Cl.: H01L 23/495, H01L 23/31, C23C 16/40, C23C 16/509

(54) **Copper base for electronic component, electronic component, and process for producing copper base for electronic component**

(30) Priority: 16.08.2005 JP 2005236052
(71) Applicant: Kabushiki Kaisha Kobe Seiko Sho (Kobe Steel, Ltd.), Kobe-shi, Hyogo 651-8585 (JP)
(72) Inventor: Hayashi Kazushi KOBE CORPORATE RESEARCH LAB., Nishi-ku Kobe-shi Hyogo 651-2271 (JP); Kugimiya Toshihiro KOBE CORPORATE RESEARCH LAB., Nishi-ku Kobe-shi Hyogo 651-2271 (JP)
(74) Representative: TBK-Patent

(57) **Abstract**

A copper base for an electronic component includes a silicon oxide thin film containing at least one of a hydrocarbon group and a hydroxy group is used, the silicon oxide thin film being disposed on a surface of the copper base. Furthermore, a silicon-containing reaction gas is decomposed by generating plasma. The resulting decomposition product is brought into contact with the copper base to form a silicon oxide thin film on a surface of the copper base.

## Description

### BACKGROUND OF THE INVENTION

### 1. Field of the Invention

The present invention relates to a copper base for an electronic component for use in an electronic component such as a semiconductor device. The present invention also relates to an electronic component including the copper base. Furthermore, the present invention relates to a method for forming a silicon oxide thin film suitable for producing the copper base for the electronic component. Specifically, the present invention relates to a copper base for an electronic component, the base having improved adhesion to a resin adhesive and a resin sealant. The present invention also relates to an electronic component including the copper base for the electronic component. Furthermore, the present invention relates to a method for forming a silicon oxide thin film suitable for producing the copper base for the electronic component.

### 2. Description of the Related Art

Copper or copper-alloy bases, as needed, the bases being plated with nickel or nickel alloys, have been used as lead frames and various substrates, such as heat dissipating substrates, in semiconductor devices, such as microprocessing units (MPU), various memory devices, and various electronic devices, such as capacitors and diodes.

The copper or copper-alloy bases (hereinafter, simply referred to as "copper bases") used in the various electronic components are bonded to the various element with resin adhesives to serve as heat sinks. Furthermore, such an element is bonded to a lead frame composed of a copper base and then sealed with a resin sealant. Thus, the adhesion between the copper base and the resin component is significantly important.

In recent years, various electronic components have been surface-mounted by reflow soldering. In particular, detachment disadvantageously occurs between the copper base and the resin component because of thermal stress due to a high-temperature environment, thereby forming a gap.

The formation of the gap reduces heat-dissipating efficiency when the copper base is used as a heat sink. The formation of the gap may cause moisture absorption through the gap when the copper base is used as a lead frame, thereby degrading the properties of the electronic component, in some cases.

A typical example of such cases is the case in a highly integrated semiconductor device, such as a microprocessing unit (MPU) or an application specific integrated circuit (ASIC).

Ball grid array packages have been used as semiconductor packages for use in the MPUs or the ASICs. In order to sufficiently express the performance of the highly integrated semiconductor device, the BGA packages include heat sinks on a surface of each semiconductor element for efficiently dissipating a large amount of heat generated in operation.

In the production of the BGA package including the heat sink, a semiconductor element having a chip composed of copper is bonded to a resin substrate composed of a glass epoxy material or the like, and the copper heat sink is bonded to the semiconductor element with a resin adhesive. In this case, a gap is formed between the semiconductor element and the heat sink because of thermal stress generated in subjecting the resulting BGA package to reflow soldering, thereby significantly degrading the dissipating efficiency, in some cases. This causes a decrease in processing speed and damage to the element.

As an example for overcoming the problems, Japanese Unexamined Patent Application Publication No. 2004-107788 (Patent Document 1) describes the following technique: in an electronic component in which the electronic element is in close contact with a copper plate (sludge) by resin molding in order to dissipate heat generated from the electronic component, a blackened film composed of copper(I) oxide is disposed on the surface to enhance the adhesion of the copper plate to the resin and to prevent the detachment of the copper plate from the resin.

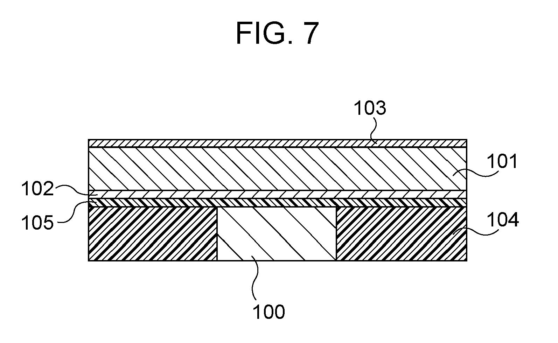

Fig. 7 is a schematic view of an example of a semiconductor device including the copper-based heat sink having the black oxide treated layer. Fig. 7 shows a semiconductor element 100, a copper-based heat sink 101, a black oxide treated layer 102, a Ni plating layer 103, a resin laminated substrate 104, and a resin adhesive layer 105 composed of a resin adhesive.

However, the formation of the black oxide treated layer has a high processing cost because of significantly complex blackening treatment. Furthermore, the resulting black oxide treated layer has low stability. Moreover, the blackening treatment requires a strong alkaline chemical solution, such as aqueous alkaline sodium chlorite solution and thus has a high burden on the environment. In addition, the detoxification of the consumed chemicals disadvantageously requires high cost.

On the other hand, in order to improve the surface hardness of a base, absorb a specific wavelength, improve gas permeability, and express a photocatalytic function, a technique of forming a thin film on the base by plasma-enhanced chemical vapor deposition (plasma-enhanced CVD) is known.

For example, Japanese Unexamined Patent Application Publication No. 2004-107788 (Patent Document 2) discloses a method for forming a silicon oxide thin film and a titanium oxide thin film on a substrate composed of a resin material, such as a polyethylene terephthalate (PET), a polycarbonate, or an acrylic resin; glass, such as white glass, soda-lime glass, alkali-free glass; quartz; or silicon, the method being applicable to the formation of coatings for use in various fields, for example, flat-panel displays (FPDs), glass for building and automobile, food packaging films.

### SUMMARY OF THE INVENTION

Accordingly, in view of the situation, it is an object of the present invention to provide a copper base for use in a lead frame that has particularly superb adhesion to a resin component used as an adhesive or a sealant in producing an electronic component; or a copper base for used in an electronic component used for a heat sink or the like for a semiconductor. It is another object of the present invention to provide an electronic component including the copper base. It is yet another object of the present invention to provide a method for forming a silicon oxide thin film to easily produce the copper base.

A copper base according to the present invention for electronic component includes a silicon oxide thin film containing at least one of a hydrocarbon group and a hydroxy group, the silicon oxide thin film being disposed on a surface of the copper base.

Copper and various copper alloys, which have satisfactory thermal conductivity and electrical conductivity, may be used as the material of the copper base used in the present invention. Examples of the material of the copper base include, but are not limited to, pure copper, Cu-Fe-P-based alloys, Cu-Ni-Si-based alloys, and Cu-Cr-Zr-based alloys.

Furthermore, if necessary, a surface of the copper base may be plated with a Ni alloy by a known method.

Examples of the Ni alloy include binary system alloys, such as Ni-Sn, Ni-Fe, Ni-P, and Ni-Co; tertiary system alloys, such as Ni-Cu-Sn, Ni-Cu-Fe, and Ni-Co-P; and other multi-system alloys.

The shape of the copper base is not limited. A desired shape suitable for a specific application, for example, a heat sink, a substrate, a lead frame, or a wire for a semiconductor device is selected.

On the other hand, an example of the silicon oxide thin film containing at least one of a hydrocarbon group and a hydroxy group and formed on the surface of the copper base is a thin film produced by plasma-enhanced CVD with a silicon-containing reaction gas including a silicon alkoxide described below.

The silicon oxide thin film according to the present invention contains a Si-O bond and at least one of a hydrocarbon group and a hydroxy group, each group resulting from a plasma decomposition product of a silicon alkoxide or a plasma decomposition product of a silicon alkoxide and an oxygen-containing molecule.

The at least one of the hydrocarbon group and the hydroxy group is a component for further improving adhesion of the copper base to a resin component used as an adhesive, a sealant, or the like. Specific examples thereof include a methyl group (-CH₃) resulting from a plasma decomposition product of tetramethoxysilane, hexamethyldisiloxane, hexamethyldisilazane, or the like; a hydrocarbon group resulting from a plasma decomposition product of a silicon alkoxide containing an ethyl group (-C₂H₅), such as tetraethoxysilane; and a hydroxy group generated by bonding the plasma decomposition product of the silicon alkoxide and the plasma decomposition product of the oxygen-containing molecule. Furthermore, examples of the at least one of the hydrocarbon group and the hydroxy group include a hydrocarbon group, a hydroxy group, and the like resulting from a plasma decomposition product of a reactive functional group-containing silicon alkoxide, such as γ-glycidoxypropyltrimethoxysilane, γ-glycidoxypropyltriethoxysilane, β-(3,4-epoxycyclohexyl)ethyltrimethoxysilane, or γ-aminopropyltriethoxysilane. These may be used alone or in combination.

The content of the at least one of the hydrocarbon group and the hydroxy group is not particularly limited. In the intensity ratio of absorbance peaks in a spectrum obtained from the measurement of a film formed on a Si substrate under the same conditions by Fourier transform infrared spectroscopy (FT-IR), the peak intensity ratio of Si-OH (3,000 to 3,400 cm⁻¹) to Si-O (1,070 to 1,080 cm⁻¹) or the peak intensity ratio of Si-CH₃, Si-C₂H₅, and Si-C₃H₈ (2,800 to 2,900 cm⁻¹) to Si-O is preferably 0.01 to 0.5 and more preferably 0.05 to 0.2. At an excessively low peak intensity ratio, the effect of improving adhesion to the resin component tends to be low. At an excessively high peak intensity ratio, the strength and durability of the film tend to be low.

The thickness of the silicon oxide thin film in accordance with the present invention is not particularly limited but is preferably about 1 to 1,000 nm and more preferably about 5 to 100 nm. An excessively large thickness of the silicon oxide thin film results in an increase in cost due to prolonged time required for the formation of the film and results in a decrease in adhesion to the copper base. An excessively small thickness of the silicon oxide thin film may lead to insufficient adhesion strength.

In particular, when the copper base according to the present invention for an electronic component is used in a semiconductor device, an excessively large thickness may reduce adhesion strength because of moisture absorption due to the heat history experienced in mounting the device by reflow soldering. Thus, the thickness is preferably 100 nm or less.

The thin film is not necessarily formed as a continuous film. For example, when a discontinuous silicon oxide thin film is in the form of stripes, the adhesion strength can be improved because of the anchor effect of the resin component.

When roughness preferably having a peak-to-valley height of 100 to 1,000 nm and more preferably 500 to 1,000 nm are formed on the surface of the silicon oxide thin film, the adhesion of the copper base to the resin component is further improved because the adhesion is improved due to an increase in surface area and the anchor effect resulting from the irregularities.

On the other hand, when a continuous, homogeneous thin film is formed, a protective tape, which has so far been required, can be omitted because the continuous, homogeneous thin film serves as a protective layer, such as a plating film.

The above-described copper base according to the present invention for an electronic component, the copper base including the silicon oxide thin film that contains the at least one of the hydrocarbon group and the hydroxy group and that is disposed on the surface of the copper base or the copper alloy base, has high adhesion to the resin component and high die shear strength. With respect to a resin failure mode in detaching the copper base of the present invention from the resin component, even in the case of a known copper base detached in an interfacial failure mode, the copper base of the present invention tends to be detached in a cohesive failure mode.

Thus, the copper base of the present invention for an electronic component is suitably used for any one of the highly integrated semiconductor devices, such as MPU and ASIC. Furthermore, the copper base of the present invention is suitably used for any one of various electronic components, such as capacitors and diodes, each including the copper base and requiring high adhesion of the copper base to a resin component.

A process for producing a copper base of the present invention for an electronic component will be descried in detail below.

As a process for producing a copper base of the present invention for an electronic component, a method for forming a silicon oxide thin film is employed, the method including the steps of introducing a silicon-containing reaction gas into a gap between at least a pair of electrodes for generating plasma by discharge; generating plasma in the gap between the electrodes to decompose the silicon-containing reaction gas into a decomposition product; and bringing a copper base or a copper alloy base into contact with the decomposition product from the silicon-containing reaction gas to form a silicon oxide thin film on a surface of the copper base or the copper alloy base.

A specific example of the method is a method with an apparatus provided with a pair of electrodes opposite to each other, the method including placing a copper base on one of the electrodes, introducing a silicon-containing reaction gas into a space between the electrode, and generating plasma to form a thin film on the copper base.

More specifically, examples thereof include low-pressure plasma-enhanced chemical vapor deposition (CVD) in which plasma is generated by glow discharge under reduced pressure conditions, for example, at a pressure of about 10 to 1000 Pa; a method proposed in Japanese Unexamined Patent Application Publication No. 6-2149 or the like, the method including generating plasma by glow discharge at a pressure near atmospheric pressure to form a thin film on a base; a method described in Japanese Unexamined Patent Application Publication No. 2002-237480, the method including forming a dielectric on at least one electrode opposite the other electrode and blowing a material gas on a base by a gas pressure while generating plasma by DC pulse or the like at atmospheric pressure; and a method disclosed in Japanese Unexamined Patent Application Publication No. 9-104985 or the like, the method including forming a film with a rotating electrode.

Among these methods described above, the method for forming a film by plasma-enhanced CVD with the rotating electrode is preferred in view that arc discharge does not easily occur because of no electric field concentration and that a thin film can be formed with high productivity because, for example, a gas flow along the rotating electrode is uniform in the width direction.

An exemplary process for producing a copper base of the present invention for an electronic component by employing a method for forming a film with a plasma-enhanced CVD apparatus including a chamber containing a rotating electrode will now be described in detail. The present invention may also be performed by a method for forming a film with a plasma-enhanced CVD apparatus including a rotating electrode without a chamber, in addition to the following method.

A method for forming a silicon oxide thin film on a copper base by plasma-enhanced CVD with an apparatus provided with a pair of electrodes opposite each other in a chamber, one of the electrode being a rotating electrode serving as a discharge electrode, includes placing a base on the electrode opposite the rotating electrode; introducing a silicon-containing reaction gas into the chamber; generating plasma in a space between the rotating electrode and the base (hereinafter, referred to as a "gap") by glow discharge at a pressure near atmospheric pressure to form a line plasma in the gap; and moving the copper base such that the copper base traverses the plasma space. According to the method, it is possible to form a film having a large area and to perform surface treatment without an enlarged apparatus.

With respect to the pair of electrodes opposite each other in the chamber, one of the electrodes is a rotating electrode, and the other electrode is a flat electrode. The copper base is placed on the flat electrode.

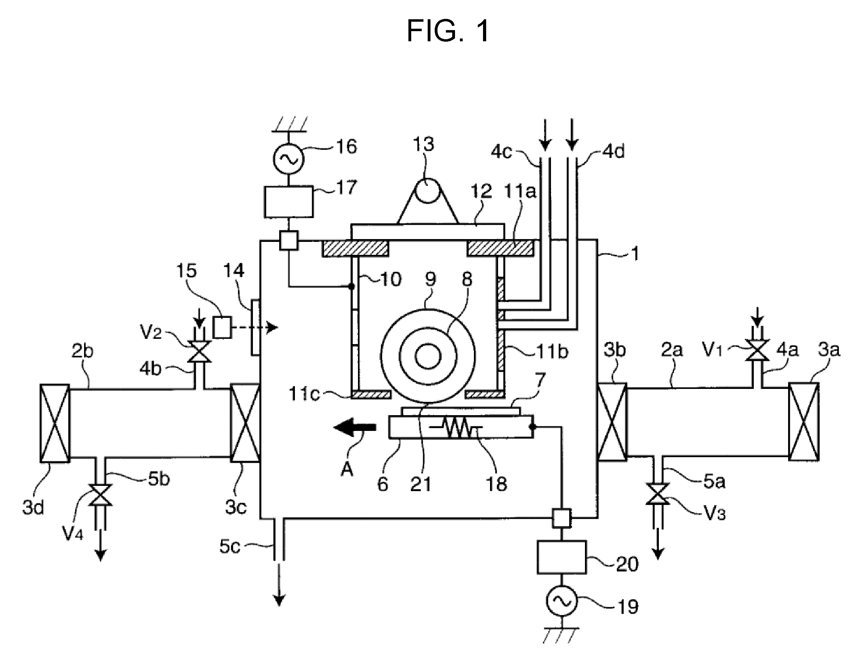

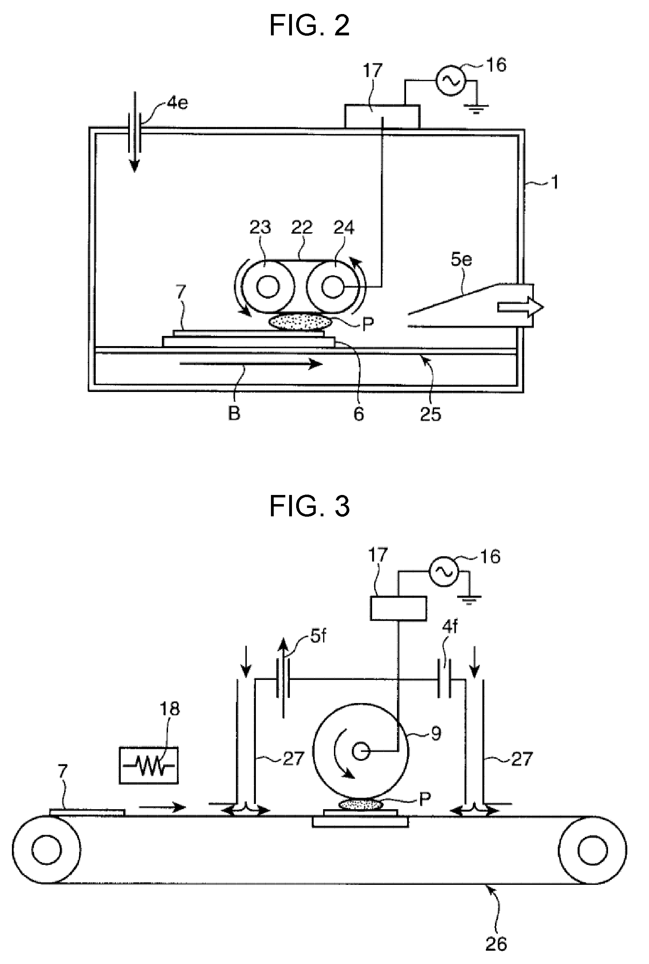

As the rotating electrode, a cylindrical rotating electrode as shown in an example of the structure of a film-forming apparatus by CVD shown in Fig. 1 described below may be used. Furthermore, an endless belt electrode as shown in Fig. 2 may also used.

The surface shape of the rotating electrode is not particularly limited but may be smooth. Irregularities such as a series of convex may also be formed on the surface. The irregularities are used in order to adjust the distance between the rotating electrode and the target position of the base. For example, when the irregularities are formed along the rotation direction, plasma can be preferentially generated at only a portion of the base, the portion facing the protrusion. As a result, the silicon oxide thin film can be preferentially formed at only the portion. Consequently, the irregularities can be formed on the surface of the silicon oxide thin film.

Furthermore, in the rotating electrode having the irregularities, there is the effect of diffusing the silicon-containing reaction gas, in which the flow of the gas is a laminar flow (viscous flow) at a pressure near atmospheric pressure.

A copper base or a copper alloy base having a desired shape in response to a specific application is placed on the electrode opposite the rotating electrode.

To improve the adhesion of the silicon oxide thin film to the copper base in the present invention, it is also effective to heat the base. The heating temperature is preferably set in the range of 70°C to 350°C so that a silicon-containing reaction gas, which is described below, does not form dew in the range. The heating temperature is set at 200°C or lower and more preferably 150°C or lower so that a discoloration-proof agent generally applied on a surface of a copper substrate does not evaporate.

The distance between the rotating electrode and the copper base placed on the electrode opposite the rotating electrode (gap distance) is appropriately adjusted in response to radio-frequency power applied to the rotating electrode, the type of silicon-containing reaction gas used, the composition, and the like. In general, the distance is preferably about 0.5 to 5 mm and more preferably about 1 to 3 mm. In the case of an excessively narrow gap, the silicon-containing reaction gas cannot be stably fed into the gap, and the nonuniformity of the gap distance in the width direction is significantly large. As a result, it is difficult to uniformly form a film. In addition, to stably generate plasma with a narrow gap, it is necessary to trap charged particles, which are electrons and ions, in plasma. Thus, a high frequency of 100 MHz or higher is required, which is disadvantageous for cost.

On the other hand, in the case of an excessively wide gap, the following problems may occur: For example, the film-forming speed decreases because of decreases in electric field and plasma density. Furthermore, the film-forming speed decreases because of the flow out of a precursor above the base due to a laminar flow generated by rotation of the rotating electrode. Moreover, the chamber is contaminated.

The circumferential velocity of the rotating electrode is preferably 3,000 cm/min or more. When the circumferential velocity is less than 3,000 cm/min, the film-forming speed tends to decrease. Thus, the circumferential velocity is preferably 10,000 cm/min or more. In view of the improvement of the yield, the circumferential velocity is preferably 100,000 cm/min or less.

The silicon-containing reaction gas is introduced into the chamber. Preferably, the pressure in the chamber is adjusted near atmospheric pressure.

The pressure near atmospheric pressure refers to a pressure of about 0.01 to 0.1 MPa. In view of ease of pressure control and a simple structure of the apparatus, the pressure is preferably in the range of about 0.08 to 0.1 MPa.

The silicon-containing reaction gas is a material gas preferably containing an inert gas, oxygen, and the like in addition to a silicon alkoxide.

Examples of the silicon alkoxide include tetraethoxysilane, tetramethoxysilane, methyltriethoxysilane, hexamethyldisiloxane, hexamethyldisilazane, γ-glycidoxypropyltrimethoxysilane, γ-glycidoxypropyltriethoxysilane, β-(3,4-epoxycyclohexyl)ethyltrimethoxysilane, and γ-aminopropyltriethoxysilane. These may be used alone or in combination. Among these, tetraethoxysilane is preferred from the standpoint of industrial availability.

In employing the plasma-enhanced CVD at a pressure near atmospheric pressure, the silicon alkoxide is a safe material because of low reactivity with O₂ even under high pressure without plasma.

The inert gas is a component for stably generating glow discharge in an atmosphere not producing a reactive radical. Examples of the inert gas include noble gases, such as He, Ar, Xe, and Kr; and gases such as N₂. At least one of these gases may be used. The inert gas is preferably He because of the long lifetime of the metastable excited state of He.

Furthermore, the silicon-containing reaction gas in the present invention may further contain other components. Specific examples of the component include silicon compounds other than the silicon alkoxides; oxygen; nitrogen oxides, such as nitric oxide (N₂O); and water.

In particular, when the silicon-containing reaction gas contains oxygen, the oxidation and crosslinking reaction of the silicon alkoxide is accelerated. At a relatively high oxygen content, it is possible to form a particle-like silicon oxide thin film for forming the silicon oxide thin film having the surface roughness.

With respect to the oxygen content, the ratio by volume of the oxygen to the silicon alkoxide, i.e., oxygen/silicon alkoxide, is preferably about 0.1 to 2. At a ratio of less than 0.1, the effect of sufficiently promoting oxidation and the crosslinking reaction is low, and silicon oxide fine particles are insufficiently grown. At a ratio exceeding 2, silicon oxide particles tend to be deposited.

With respect to preferred contents of the components in the silicon-containing reaction gas, the silicon alkoxide content is 0.1 to 5 percent by volume and more preferably 1 to 5 percent by volume at 1 atom. The oxygen content is preferably about 0 to 10 percent by volume at 1 atom.

In this method, high-frequency power is applied to the discharge electrode to generate glow discharge, thereby producing plasma.

In this case, the time from the ionization of the molecules of the silicon-containing reaction gas by glow discharge to the recombination of the ionized molecules is short. Furthermore, the mean free path of electrons is also short. Thus, to stably generate glow discharge in the narrow gap between the electrodes, it is necessary to trap charged particles of electrons and ions.

Therefore, in applying high-frequency power to the rotating electrode, frequencies of 100 KHz or more may be used. In particular, high frequencies of 10 MHz or more is preferred. Use of high frequencies of 10 MHz or more, i.e., use of, for example, a frequency of 13.56 MHz, which is most readily available commercial frequency, 70 MHz, 100 MHz, or 150 MHz, which is available as a power supply, improves plasma density, thus generating stable plasma.

### BRIEF DESCRIPTION OF THE DRAWINGS

Fig. 1 is a schematic illustration of the structure of a film-forming apparatus by CVD according to an embodiment of the present invention;
Fig. 2 is a schematic illustration of the structure of a film-forming apparatus by CVD according to another embodiment of the present invention;
Fig. 3 is a schematic illustration of the structure of a film-forming apparatus by CVD according to another embodiment of the present invention;
Fig. 4 is a schematic illustration of the structure of a film-forming apparatus by CVD according to another embodiment of the present invention;
Figs. 5A and 5B are each a chart showing the absorbance spectrum of a silicon oxide thin film obtained in EXAMPLE 1 by FT-IR;

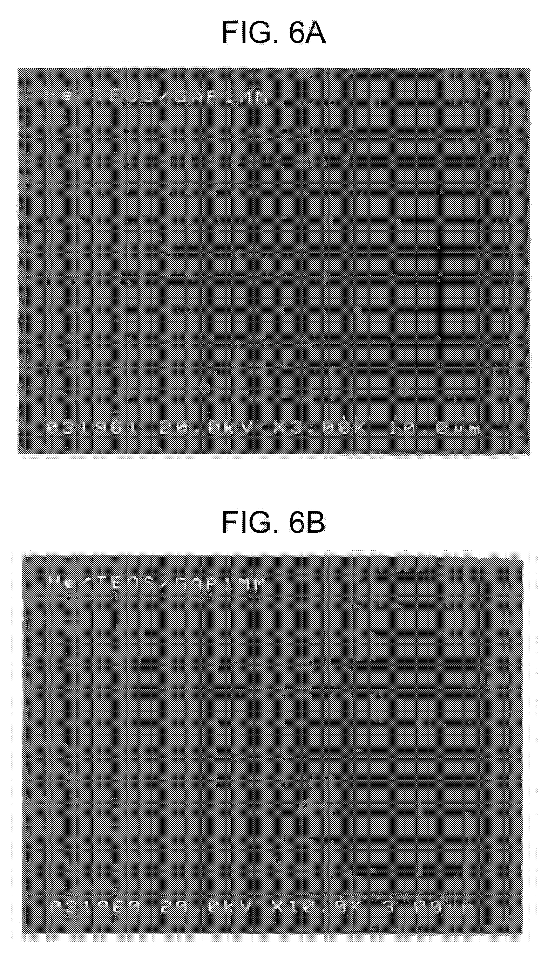

Figs. 6A and 6B are each a scanning electron micrograph of surface roughness obtained in EXAMPLE 24, the micrograph being in place of a figure, Fig. 6A being at a magnification of x3,000, and Fig. 6B being at a magnification of ×10,000; and
Fig. 7 is a schematic cross-section of a known semiconductor device.

### DESCRIPTION OF THE PREFERRED EMBODIMENTS

Fig. 1 is a schematic illustration of the structure of a film-forming apparatus by CVD, the apparatus being used for forming a silicon oxide thin film suitably used in a process for producing a copper base according to the present invention for an electronic component. In the figure, a film-forming chamber 1, a load lock chamber 2a for introducing a base, a load lock chamber 2b for taking out the base, gate valves 3a to 3d, gas inlets 4a to 4d, leak ports 5a to 5c, a base holder 6, a base 7, a bearing 8, a rotating electrode 9, a support 10, insulators 11a to 11c for supporting the rotating electrode, synthetic quartz glass 12, a near-infrared lamp 13, an observation window 14, a radiation thermometer 15, radio-frequency power sources 16 and 19, matching boxes 17 and 20, a heater 18 in the base holder, and a glow discharge region 21 (plasma generation region) are shown.

In the structure of the apparatus shown in Fig. 1, the load lock chamber 2a for introducing the base is connected to the film-forming chamber 1 via the gate valve 3b, and the load lock chamber 2b for taking out the base is connected to the film-forming chamber 1 via the gate valve 3c. An inert gas, such as He, is always introduced into the load lock chambers 2a and 2b from the gas inlets 4a and 4b (flow control valves V1 and V2). The pressures in the load lock cambers are adjusted with the leak ports 5a and 5b attached to the load lock chambers 2a and 2b, respectively (flow control valves V3 and V4). As a result, the load lock chambers 2a and 2b are maintained at normal pressures (about 0.1 MPa).

A mixed gas of an inert gas such as He and, if necessary, oxygen (O₂) is introduced from the gas inlet 4c while being flow-controlled with a mass flow controller (not shown). A silicon alkoxide diluted by bubbling with an inert gas such as He is introduced from the gas inlet 4d while being flow-controlled with a mass flow controller (not shown). The pressure in the film-forming chamber 1 is controlled by adjusting a flow rate in the leak port 5c.

The base 7 is placed on the base holder 6. The gate valve 3a is open, and then the base holder 6 is transferred and placed into the load lock chamber 2a. The gate valve 3a is closed, and then the gate valve 3b is opened. The base holder 6 is transferred in the direction of arrow A and placed in the film-forming chamber 1. Then, the gate valve 3b is closed.

A silicon oxide thin film is formed on the surface of the base 7 on the base holder 6 while the base holder 6 is placed in the film-forming chamber 1. After the formation of the silicon oxide thin film on the base 7, the gate valve 3c is opened, and the base holder 6 is transferred into the load lock chamber 2b. Subsequently, the gate valve 3c is closed, and then the gate valve 3d is opened. The base holder 6 and the base 7 on the base holder 6 are taken out from the load lock chamber 2b. A series of operations are continuously performed. The stop and transfer of the base holder 6 can be desirably controlled.

To prevent the condensation of the silicon alkoxide, which is a liquid material at room temperature, on the inner walls and the like of the film-forming chamber 1, it is preferred that heaters (not shown) are attached to the outer walls of the film-forming chamber 1, the load lock chambers 2a and 2b, and the like, and each wall is heated to about 100°C. For the same reason, the temperatures of the support 10 for supporting the rotating electrode 9, the insulators 11a to 11c, and the like are preferably adjusted to about 100°C with built-in heaters. Furthermore, the rotating electrode 9 is preferably heated to about 150°C by infrared rays emitted from the insulating layer 13 through the synthetic quartz glass 12. The temperature of the rotating electrode 9 is monitored with the radiation thermometer 15 via the observation window 14 composed of BaF₂ or the like.

In the apparatus, plasma is generated in the gap between the rotating electrode 9 and the base 7 by glow discharge region to form a silicon oxide thin film on the base 7. The principle of the film formation will be described below. The rotating electrode 9 is composed of aluminum or the like. For example, the rotating electrode 9 has a cylindrical shape and has a width of about 120 mm and a diameter of about 100 mm. To prevent the electric field concentration, edges of the rotating electrode 9 are rounded and each has a radius of curvature of R5 (mm). Furthermore, to prevent arcing, the surface of the rotating electrode 9 has a dielectric coating. For example, the dielectric coating having a thickness of about 150 µm is composed of white alumina formed by thermal spraying.

The surface of the rotating electrode 9 forming the gap between the rotating electrode 9 and the base 7 is polished. If necessary, irregularities are formed. The rotating electrode 9 is supported by the bearing 8 and the support 10. A shaft end of the rotating electrode 9 is magnetically coupled with a magnet on an end of a motor (not shown) disposed outside the film-forming chamber 1. The rotating electrode 9 can be rotated at 0 to 3,000 rpm.

The support 10 is composed of stainless steel or the like. Radio-frequency power can be applied to the support 10 from the radio-frequency power source 16 via the matching box 17. When the front end of the base holder 6 is transferred to a position directly below the rotating electrode 9, the radio-frequency power is applied to initiate glow discharge in a space between the rotating electrode 9 and the base holder 6 (that is, the base holder 6 corresponds to the electrode opposite the rotating electrode). After the base 7 on the base holder 6 is transferred to a position directly below the rotating electrode 9, glow discharge is performed in a gap between the rotating electrode 9 and the base 7.

The heater 18 is installed in the base holder 6. The heater 18 can heat the base holder 6 from room temperature to about 300°C. The base holder 6 has a white alumina coating having a thickness of about 100 µm on the surface thereof, the coating being formed by thermal spraying. Basically, the base holder 6 may be grounded. Alternatively, as shown in Fig. 1, radio-frequency power may be applied to the base holder 6 from the radio-frequency power source 19 via the matching box 20. In this way, the application of radio-frequency power to the base holder 6 increases plasma density and expresses the effect of confining plasma. With respect to the start timing of the application of power from the radio-frequency power source 19 to the base holder 6, radio-frequency power is required to be applied immediately after the application of power from the radio-frequency power source 16 to the rotating electrode 9.

The matching box 17 has the following functions: for example, frequency tuning and an impedance adjustment in order to match the radio-frequency power source 16 side to the load side including the matching box 17; maximization of the power consumption of the entire load circuit including the matching box 17; and protection of the radio-frequency power source 16 and a high-frequency oscillation circuit (the relationship between the matching box 20 and the radio-frequency power source 19 is the same as the above).

Fig. 2 is a schematic illustration of the structure of a film-forming apparatus by CVD according to another embodiment of the present invention. The basic structure is similar to that shown in Fig. 1. Equivalent elements are designated using the same reference numerals, and redundant description is not repeated. In Fig. 2, the load lock chamber 2a for introducing the base, the load lock chamber 2b for taking out the base, and components attached to the load lock chambers 2a and 2b are disposed (not shown, for the sake of convenience) in the same way as the apparatus shown in Fig. 1.

In the structure of the apparatus shown in Fig. 2, an endless belt electrode 22 is disposed in place of the rotating electrode 9. The endless belt electrode 22 is composed of conductive thin steel. The endless belt electrode 22 is stretched between two rollers 23 and 24 so as to run.

The rollers 23 and 24 have cylindrical peripheries. These rollers 23 and 24 are disposed such that the surface of the endless belt electrode 22 is parallel to the horizontally extending surface of the base 7 and such that the distance between the surface of the endless belt electrode 22 and the surface of the base 7 is maintained at a constant interval in a plasma-generating region P. The endless belt electrode 22 rotates so as to run in the same direction as the direction of movement of the base 7 in the plasma-generating region P.

Between the rollers 23 and 24, the roller 24 is disposed at the right side of Fig. 2. The roller 24 is composed of a metal. The roller 24 functions as a driving roller and a power-feeding roller. The roller 24 is rotated by a belt-driving motor (not shown). The base 7 on the base holder 6 in the film-forming chamber 1 is transferred in the horizontal direction (in the direction of arrow B) with a base transfer mechanism 25.

In the film-forming apparatus by plasma-enhanced CVD shown in Fig. 2, the silicon-containing reaction gas is introduced from a gas inlet 4e into the film-forming chamber 1 while the gas is exhausted through an exhaust duct 5e to maintain the pressure in the film-forming chamber 1 at a predetermined pressure. The endless belt electrode 22 is driven with the rollers 23 and 24. Line plasma having a relatively wide width is generated in the gap between the endless belt electrode 22 and the base 7 by glow discharge. Then, the silicon oxide thin film is formed on the base 7 by chemical reaction of the gas while the base 7 is transferred.

Fig. 3 is a schematic illustration of a film-forming apparatus by CVD according to another embodiment of the present invention, the apparatus including a rotating electrode. In this example, productivity is enhanced by omitting the exhaust and replacement of the gas, and it is possible to introduce the base directly from air and take out to avoid use of an expensive vacuum vessel. The basic structure of the rotating electrode portion is the same as that in Fig. 1. The description of the same portion is omitted.

In this apparatus, the base 7 is transferred by a belt conveyor 26 in a single direction. The base 7 is placed by a substrate handling robot (not shown) on an end of the belt conveyor at constant intervals. Then, the base 7 is introduced into a reaction vessel with movement of the belt conveyor.

In this apparatus, an entrance (exit) is limited to the bare minimum size needed to transfer the base 7. An air curtain 27 is provided to block air by using gas flow. The reaction space is filled with an inert gas. A material gas fed separately is introduced into a plasma space by a flow generated by motion of the rotating electrode 9, and the silicon oxide thin film is formed on the base.

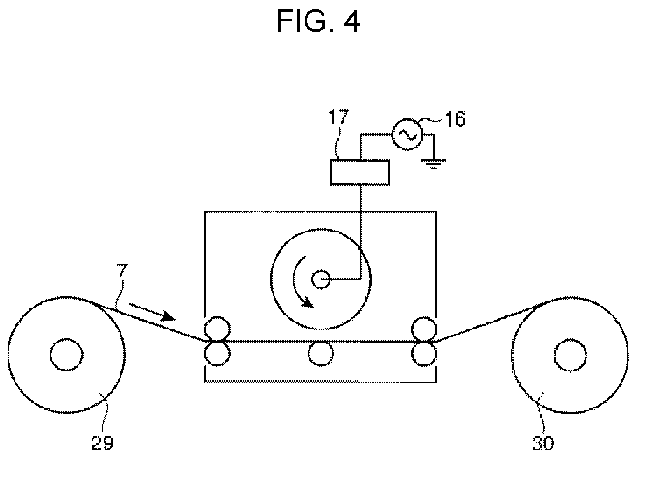

Fig. 4 is a schematic illustration of a film-forming apparatus by CVD according to another embodiment of the present invention, the apparatus including a rotating electrode.

In this apparatus, the base 7 is in the form of a coil. The base 7 is unreeled from a supply roll 29 and then reeled into a take-up roll 30. A reaction vessel includes gas-blocking rolls 31 for separating the reaction vessel from air, the gas-blocking rolls 31 being disposed at an entrance and an exit. This structure enables continuous treatment of the base 7, thereby significantly improving productivity.

The operation and effect of the present invention will be described in more detail by examples. However, the following examples are not limited to the present invention. Modifications made without departing from the scope of the present invention described above and below is included in the technical range of the present invention.

### EXAMPLES

### EXAMPLES 1 TO 11

A silicon oxide thin film was formed with the film-forming apparatus by CVD shown in Fig. 1, the apparatus including a rotating electrode.

In the figure, the base holder 6 having a width of 170 mm and a length (length in the transfer direction) of 170 mm was used. The base 7 was placed on the base holder 6 and then placed in the chamber 1.

The base 7 had a width of 100 mm, a length (length in the transfer direction) of 150 mm, and a thickness of 0.4 mm and was composed of a copper alloy having a composition of Cu-0.1 percent by mass of Fe-0.03 percent by mass of P (C19210), the copper alloy being plated with Ni or a Ni alloy.

After the front end of the base holder 6 was transferred to a position directly below the rotating electrode 9, radio-frequency power (13.56 MHz, 500 W) was applied from the radio-frequency power source 16 to the rotating electrode 9. The base holder 6 was grounded.

The temperature of the base holder 6 was set at 100°C to 250°C. The temperature of the rotating electrode 9 was set at 150°C. The temperature of the film-forming chamber 1 and components attached to the chamber was set at 100°C.

The number of rotations of the rotating electrode 9 was set at 500 to 1,500 rpm (circumferential velocity: 15,000 to 45,000 cm/min). The gap distance between the rotating electrode 9 and the base 7 was set at 1 mm. The transfer speed of the base 7 was 3.3 to 17 mm/s. Thus, the discharge time between ends of the base 7 in the transfer direction was about 8 to 51 seconds.

The pressure in the film-forming chamber 1 was controlled with an automatic pressure control (not shown) disposed at the leak port 5c. IN this production example, the total pressure was adjusted to 101 kPa. A reaction gas introduced into the film-forming chamber 1 is a mixed gas of He and tetraethoxysilane (TEOS). The partial pressure of each gas was adjusted by flow control.

The partial pressure of TEOS was set in the range of 0.101 to 5.05 kPa (the ratio of the partial pressure to the total pressure = 0.101/101 to 5.05/101 = 0.1% to 5%). The partial pressure of TEOS was changed in the above range, and a silicon oxide thin film was formed.

The thickness of the resulting silicon oxide thin film was determined by measuring the step height between the resulting film and a masked region on the base with a Dektak stylus profiler. As a result, as shown in Table 1, the resulting silicon oxide thin film formed on the copper alloy base had a thickness of 1 to 1,000 nm.

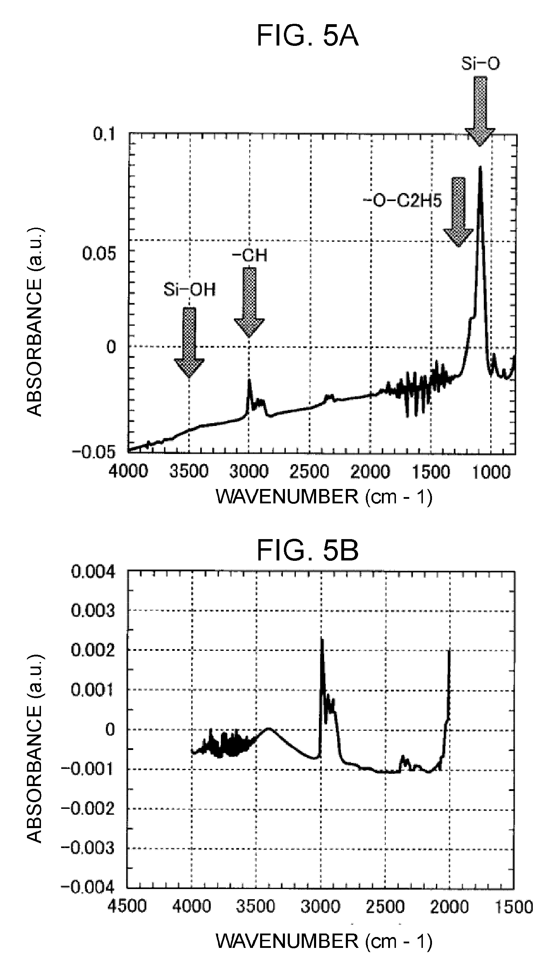

The same silicon oxide thin film was formed on a Si substrate under the same conditions. Organic components in the film were analyzed by transmission Fourier transform infrared spectroscopy (FT-IR). Figs. 5A and 5B each show a typical IR chart resulting from the measurement of a film obtained in EXAMPLE 1.

In Figs. 5A and 5B, the peak observed at a frequency of about 3,000 to 3,400 cm⁻¹ is assigned to a -OH group in the thin film, and the peak observed at a frequency of about 2,800 to 2,900 cm⁻¹ is assigned to alkyl groups (methyl group and ethyl group).

The measurement was performed by transmission Fourier transform infrared spectroscopy. As a result of analysis in an absorption mode, it was confirmed that a hydroxy group, a methyl group, and an ethyl group were present.

The adhesion of a resin to the copper base for an electronic component, the copper base having the silicon oxide thin film on the resulting surface, was evaluated according to the following method.

### (Evaluation of Die Shear Strength)

A silicon chip (manufactured by Kojundo Chemical Lab. Co., Ltd.) having a thickness of 1 mm and a size of 5 × 5 mm was bonded on the surface of the copper base for an electronic component with a thermosetting polyolefin resin (model: 1592, manufactured by Sumitomo 3M Limited). The resin was cured at 150°C for 2 hours.

Then, the die shear strength of the silicon chip bonded to the surface of the copper base for the electronic component was measured with a die shear strength evaluation system according to U.S. MIL STD-883.

To evaluate moisture resistance, the die shear strength was measured after performing a pressure cooker test at 105°C and 100%RH for 24 hours.

Table 1 shows the results.

**Table 1**

| EXAMPLE | | 1 | 2 | 3 | 4 | 5 | 6 | 7 | 8 | 9 | 10 | 11 |
|---|---|---|---|---|---|---|---|---|---|---|---|---|
| Thin film- forming conditions | Partial pressure of TEOS (kPa) | 0.107 | 0.267 | 0.133 | 0.267 | 0.267 | 0.533 | 0.667 | 0.667 | 0.933 | 1.600 | 2.666 |
| | Partial pressure of Helium (kPa) | 101.218 | 101.058 | 101.191 | 101.058 | 101.058 | 100.791 | 100.658 | 100.658 | 100.391 | 99.725 | 98.658 |
| | Partial pressure of oxygen (kPa) | 0 | 0 | 0 | 0 | 0 | 0 | 0 | 0 | 0 | 0 | 0 |
| | Total pressure (kPa) | 101.32 | 101.32 | 101.32 | 101.32 | 101.32 | 101.32 | 101.32 | 101.32 | 101.32 | 101.32 | 101.32 |
| | Temperature of base holder (°C) | 200 | 150 | 100 | 120 | 100 | 200 | 200 | 250 | 100 | 150 | 200 |
| Thickness (nm) | | 1 | 10 | 50 | 75 | 100 | 120 | 160 | 200 | 300 | 500 | 1000 |
| Adhesion strength | Die shear strength (room temperature) (MPa) | 14.71 | 17.652 | 19.613 | 21.575 | 19.613 | 17.652 | 13.729 | 14.71 | 11.768 | 14.71 | 11.768 |
| | Die shear strength (high temperature and high humidity) (MPa) | 12.503 | 15.004 | 16.671 | 18.338 | 16.671 | 15.004 | 11:67 | 12.503 | 10.003 | 12.503 | 10.003 |
| | Die shear strength retention (%) | 85 | 80 | 95 | 90 | 85 | 65 | 65 | 60 | 55 | 50 | 40 |

### EXAMPLES 12 TO 23

Samples were prepared and evaluated as in EXAMPLES 1 to 11, except that when the thicknesses of the silicon oxide thin films were 20, 40, 250, and 500 nm, oxygen was added such that the partial pressure of oxygen was 0.1 to 2 times that of TEOS (0.133 to 2.66 kPa). Table 2 shows the results.

**Table 2**

| EXAMPLE | | 12 | 13 | 14 | 15 | 16 | 17 | 18 | 19 | 20 | 21 | 22 | 23 |
|---|---|---|---|---|---|---|---|---|---|---|---|---|---|
| Thin film- forming conditions | Partial pressure of TEOS (kPa) | 0.1333 | 0.1333 | 0.1333 | 0.2666 | 0.2666 | 0.2666 | 0.9333 | 0.9333 | 0.9333 | 2.6664 | 2.6664 | 2.6664 |
| | Partial pressure of Helium (kPa) | 101.18 | 101.06 | 100.92 | 101.03 | 100.79 | 100.52 | 100.3 | 99.458 | 98.525 | 98.632 | 95.992 | 93.325 |
| | Partial pressure of oxygen (kPa) | 0.0133 | 0.1333 | 0.2666 | 0.0267 | 0.2666 | 0.5333 | 0.0933 | 0.9333 | 1.8665 | 0.0267 | 2.6664 | 5.3329 |
| | Total pressure (kPa) | 101.32 | 101.32 | 101.32 | 101.32 | 101.32 | 101.32 | 101.32 | 101.32 | 101.32 | 101.32 | 101.32 | 101.32 |
| | Partial pressure of oxygen/partial pressure of TEOS | 0.1 | 1 | 2 | 0.1 | 1 | 2 | 0.1 | 1 | 2 | 0.1 | 1 | 2 |
| | Temperature of base holder (°C) | 200 | 200 | 200 | 200 | 200 | 200 | 200 | 200 | 200 | 200 | 200 | 200 |
| Thickness (nm) | | 20 | 20 | 20 | 40 | 40 | 40 | 250 | 250 | 250 | 500 | 500 | 500 |
| Die shear strength (room temperature) (MPa) | | 17.652 | 11.768 | 14.71 | 11.768 | 15.691 | 17.652 | 14.71 | 13.729 | 17.652 | 16.671 | 14.71 | 14.71 |

### EXAMPLE 24

Sample was prepared as in EXAMPLES 1 to 11, except that the film-forming temperature was set at 100°C. As a result, the migration of active species generated by plasma decomposition was suppressed on the surface to form irregularities on the surface. The thickness was set at 200 nm. The resulting film was evaluated on the surface morphology with an atomic force microscope (AFM). It was conformed that the peak-to-valley (P-V) height of a surface was 1 µm or less. The die shear strength was 22 MPa. That is, the die shear strength was significantly increased.

### COMPARATIVE EXAMPLE 1

As a comparative example, a silicon oxide thin film that does not contain a hydroxy group or an alkyl group was formed on a copper plate. The same comparison was performed. The film was formed by magnetron sputtering. Plasma was generated by applying RF power. The silicon oxide thin film was formed by sputtering a SiO₂ target with argon ions generated by plasma. The thickness of the resulting film was adjusted to 10 to 200 nm by changing sputtering time on the basis of a film-forming speed previously calculated.

As a result of the same evaluation as that in examples, the die shear strength slightly increased. This may be due to the anchor effect. However, after moisture absorption, in any sample, the die shear strength significantly decreased. Furthermore, the detachment between the copper plate and the adhesive was observed. Thus, a sufficient effect was not obtained.

A copper base for an electronic component includes a silicon oxide thin film containing at least one of a hydrocarbon group and a hydroxy group is used, the silicon oxide thin film being disposed on a surface of the copper base. Furthermore, a silicon-containing reaction gas is decomposed by generating plasma. The resulting decomposition product is brought into contact with the copper base to form a silicon oxide thin film on a surface of the copper base.

## Claims

1. A copper base for an electronic component, comprising:
a silicon oxide thin film containing at least one of a hydrocarbon group and a hydroxy group, the silicon oxide thin film being disposed on a surface of the copper base.

2. The copper base for the electronic component according to claim 1, wherein the hydrocarbon group is a methyl group or an ethyl group.

3. The copper base for the electronic component according to claim 1 or 2, wherein the thickness of the silicon oxide thin film is 1 to 1,000 nm.

4. The copper base for the electronic component according to any one of claims 1 to 3, wherein the silicon oxide thin film has surface roughness on a surface of the silicon oxide thin film, and the peak-to-valley height of the roughness is 1,000 nm or less.

5. A copper base for an electronic component, comprising:
a copper base or a copper alloy base; and
a silicon oxide thin film on a surface of the copper base or the copper alloy base, wherein the silicon oxide thin film is formed by introducing a silicon-containing reaction gas into a gap between at least a pair of electrodes for generating plasma by discharge; generating plasma in the gap between the electrodes to decompose the silicon-containing reaction gas into a decomposition product; and bringing a copper base or a copper alloy base into contact with the decomposition product from the silicon-containing reaction gas.

6. An electronic component including the copper base for the electronic component according to any one of claims 1 to 5.

7. A process for producing a copper base for an electronic component, the process comprising the steps of:
introducing a silicon-containing reaction gas into a gap between at least a pair of electrodes for generating plasma by discharge;
generating plasma in the gap between the electrodes to decompose the silicon-containing reaction gas into a decomposition product; and
bringing a copper base or a copper alloy base into contact with the decomposition product from the silicon-containing reaction gas to form a silicon oxide thin film on a surface of the copper base or the copper alloy base.

8. The process for producing the copper base for the electronic component according to claim 7, wherein the silicon-containing reaction gas contains a silicon alkoxide.

9. The process for producing the copper base for the electronic component according to claim 7 or 8, wherein the pressure in the gap between the pair of electrodes is adjusted to a pressure near atmospheric pressure, and the plasma is generated by glow-discharging the silicon-containing reaction gas.
